# DEMANDE DE BREVET EUROPEEN

(11) **EP 3 763 846 A1**
(43) Date de publication de la demande: **13.01.2021**
(21) Numéro de dépôt: 20182137.8
(22) Date de dépôt: 25.06.2020
(51) Int. Cl.: C23C 16/30, C23C 16/455

(54) **PROCEDE DE FABRICATION D'UN FILM EN DISULFURE DE VANADIUM ET FILM SUSCEPTIBLE D'ETRE OBTENU PAR CE PROCEDE**

(30) Priorité: 09.07.2019 FR 1907688
(71) Demandeur: Commissariat à l'Energie Atomique et aux Energies Alternatives, 75015 Paris (FR)
(72) Inventeur: GASSILLOUD, Rémy, 38054 GRENOBLE CEDEX 09 (FR); CADOT, Stéphane, 38054 GRENOBLE CEDEX 09 (FR); FRACCAROLI, Mathias, 38054 GRENOBLE CEDEX 09 (FR)
(74) Mandataire: Cabinet Camus Lebkiri

(57) **Abrégé**

Un aspect de l'invention concerne un procédé (100) de fabrication d'un film (200) en disulfure de vanadium par dépôt chimique en phase vapeur sur un substrat préalablement chauffé, comportant des étapes successives réalisées dans un réacteur sous vide :
i. Injection d'au moins une molécule organométallique de vanadium, le vanadium ayant une valence inférieure ou égale à 4 (101) ;
ii. Purge du réacteur (102) ;
iii. Injection d'au moins une molécule soufrée comportant au moins un groupement thiol libre ou formant un intermédiaire réactionnel comportant au moins un groupement thiol libre (103) ;
iv. Injection d'un gaz réducteur (104).

## Description

### DOMAINE TECHNIQUE DE L'INVENTION

Le domaine technique de l'invention est celui des procédés de fabrication de films et plus particulièrement celui des procédés de fabrication de films en disulfure de vanadium.

La présente invention concerne un procédé de fabrication d'un film et en particulier un procédé de fabrication d'un film en disulfure de vanadium. La présente invention concerne également un film en disulfure de vanadium obtenu par le procédé.

### ARRIERE-PLAN TECHNOLOGIQUE DE L'INVENTION

Le disulfure de vanadium est connu pour ses propriétés de conductivité et de travail de sortie élevées. On entend par « conductivité », l'aptitude d'un matériau à laisser les charges électriques se déplacer de manière à autoriser le passage d'un courant électrique et on entend par « travail de sortie », l'énergie minimum à fournir à un électron d'un métal pour l'arracher de ce métal.

À ce titre, le disulfure de vanadium est couramment utilisé comme électrode, et en particulier comme électrode dans les batteries.

Le disulfure de vanadium est classiquement obtenu par une méthode solvothermale qui conduit à la formation d'une poudre fine de disulfure de vanadium qui est ensuite étalée sur un substrat pour former une électrode.

Il est également connu de synthétiser du disulfure de vanadium par dépôt par voie chimique sous vide en faisant réagir une molécule de chlorure de vanadium (III) VCI3 avec du soufre S élémentaire dans un four tubulaire placé à une température comprise entre 450°C et 500°C. Le dépôt ainsi obtenu présente des zones cristallines disjointes de sulfure de vanadium de quelques microns de large.

Quelle que soit la méthode de l'art antérieur employée, le disulfure de vanadium obtenu ne peut pas être déposé de manière conforme sur un substrat et n'est pas compatible avec un dépôt uniforme sur une grande surface, par exemple sur une surface circulaire ayant un diamètre de l'ordre de 300 mm. Le champ d'application du disulfure de vanadium ainsi obtenu est donc considérablement limité.

Il existe donc un besoin de synthétiser du disulfure de vanadium qui puisse être déposé de manière conforme et uniforme sur un substrat de grande surface.

### RESUME DE L'INVENTION

L'invention offre une solution aux problèmes évoqués précédemment, en permettant d'obtenir un film de disulfure de vanadium déposé de manière uniforme et conforme sur un substrat ayant par exemple une surface circulaire ayant un diamètre de l'ordre de 300 mm.

Un premier aspect de l'invention concerne un procédé de fabrication d'un film en disulfure de vanadium par dépôt chimique en phase vapeur sur un substrat préalablement chauffé, comportant des étapes successives réalisées dans un réacteur sous vide :
i. Injection d'au moins une molécule organométallique de vanadium, le vanadium ayant une valence inférieure ou égale à 4 ;
ii. Purge du réacteur ;
iii. Injection d'au moins une molécule soufrée comportant au moins un groupement thiol libre ou formant un intermédiaire réactionnel comportant au moins un groupement thiol libre ;
iv. Injection d'un gaz réducteur.

Grâce à l'invention, la molécule organométallique de vanadium se fixe sur le substrat puis réagit avec la molécule soufrée pour former un film de disulfure de vanadium. Le fait que le réacteur soit sous vide permet d'éviter la contamination de la molécule soufrée par le dioxygène de l'air. L'injection de dihydrogène permet de réactiver les sites de nucléation en surface pour que la croissance du film puisse se poursuivre si besoin, en réitérant le procédé. La purge permet de garantir le non-mélange de gaz pour limiter la formation de poudres. A la fin du procédé, le substrat est uniformément recouvert d'un film de disulfure de vanadium qui conserve ses propriétés de conductivité et de travail de sortie élevés et qui est conforme à la surface du substrat qui peut être plus ou moins grande. De plus, le film ainsi obtenu est transparent et est donc compatible avec des applications optiques, comme par exemple une utilisation en tant qu'électrode conductrice pour les écrans. On entend par « le film est transparent », que le film déposé sur un substrat transparent présente une transmittance supérieure ou égale à 50% pour une longueur d'onde donnée et pour une épaisseur donnée et on entend par « substrat transparent » un substrat présentant une transmittance supérieure ou égale à 50% pour une longueur d'onde donnée.

Outre les caractéristiques qui viennent d'être évoquées dans le paragraphe précédent, le procédé selon un premier aspect de l'invention peut présenter une ou plusieurs caractéristiques complémentaires parmi les suivantes, considérées individuellement ou selon toutes les combinaisons techniquement possibles.

Selon une variante de réalisation, les étapes i. à iv. sont répétées une pluralité de fois.

Ainsi, lors du premier cycle, la molécule organométallique de vanadium se fixe sur le substrat puis réagit avec la molécule soufrée pour former un film de disulfure de vanadium et lors des cycles suivants, la molécule organométallique de vanadium se fixe à la surface du film précédemment créé puis réagit avec la molécule soufrée pour faire croître le film de disulfure de vanadium.

Selon une variante de réalisation compatible avec la variante de réalisation précédente, le substrat est chauffé à une température comprise entre 100°C et 250°C.

Ainsi, la température du substrat permet d'accélérer les réactions sans brûler les molécules.

Selon une variante de réalisation compatible avec les variantes de réalisation précédentes, la molécule organométallique de vanadium est injectée pure.

Selon une variante de réalisation compatible avec les variantes de réalisation précédentes excepté la variante de réalisation précédente, la molécule organométallique de vanadium est injectée diluée dans un solvant.

Ainsi, on injecte moins de molécule organométallique de vanadium à chaque cycle.

Selon une variante de réalisation compatible avec les variantes de réalisation précédentes, la molécule organométallique de vanadium est choisie parmi les molécules suivantes : tétrakis(éthylméthylamino)vanadium(IV) TEMAV, tétrakis(diméthylamido)vanadium(IV) TDMAV, tétrakis(diéthylamino)vanadium(IV) TDEAV, tétrachlorure de vanadium VCl₄, chlorure de vanadium(III) VCl₃, bromure de vanadium VBr₃, les molécules comportant une fonctionnalisation cyclopentadiényle et/ou comportant une fonctionnalisation carbonyle ou les molécules halogénées de valence inférieure ou égale à 4.

Ainsi, la molécule organométallique de vanadium est au plus de valence IV, ce qui évite d'avoir à réaliser une étape de réduction après le procédé pour obtenir un film en disulfure de vanadium.

Selon une variante de réalisation compatible avec les variantes de réalisation précédentes, la purge est réalisée par débit d'un gaz neutre.

Selon une variante de réalisation compatible avec les variantes de réalisation précédentes, la molécule soufrée est choisie parmi les molécules suivantes : éthane di-thiol EDT, sulfure d'hydrogène H₂S, disulfure de diméthyle DMDS, disulfure de diéthyl DEDS, disulfure de dipropyl DPDS, disulfure de dibenzyl DBDS, disulfure de di-tert-butyl DTBDS.

Selon une variante de réalisation compatible avec les variantes de réalisation précédentes, la molécule soufrée est mélangée avec du dihydrogène.

Selon une variante de réalisation compatible avec les variantes de réalisation précédentes, la molécule soufrée est injectée pure.

Selon une variante de réalisation compatible avec les variantes de réalisation précédentes excepté la variante de réalisation précédente, la molécule soufrée est injectée en mélange avec un gaz porteur neutre.

Ainsi, on injecte moins de molécule soufrée à chaque cycle.

Selon une variante de réalisation compatible avec les variantes de réalisation précédentes, la molécule soufrée est injectée avec un plasma réducteur.

Ainsi, le temps de greffage de la molécule soufrée est diminué.

Selon une variante de réalisation compatible avec les variantes de réalisation précédentes, le gaz réducteur injecté est du dihydrogène.

Selon une variante de réalisation compatible avec les variantes de réalisation précédentes, le gaz réducteur est injecté pur.

Selon une variante de réalisation compatible avec les variantes de réalisation précédentes excepté la variante de réalisation précédente, le gaz réducteur est injecté en mélange avec un gaz porteur neutre.

Ainsi, on injecte moins de gaz réducteur à chaque cycle.

Selon une variante de réalisation compatible avec les variantes de réalisation précédentes, l'étape d'injection du gaz réducteur comporte une sous-étape de traitement plasma réducteur à base de dihydrogène.

Ainsi, le temps global du procédé est réduit.

Selon une variante de réalisation compatible avec les variantes de réalisation précédentes, la surface du substrat est préparée par débit de gaz réducteur.

Ainsi, l'oxygène résiduel et les condensats humides sont éliminés du réacteur, ce qui permet d'accélérer la réaction.

Selon une sous-variante de réalisation compatible avec la sous-variante de réalisation précédente, la préparation de la surface du substrat comporte une sous-étape de traitement plasma.

Ainsi, le temps global du procédé est réduit.

Selon une sous-variante de réalisation compatible avec les sous-variantes de réalisation précédentes, la préparation de la surface du substrat comporte une sous-étape d'exposition à une molécule soufrée.

Ainsi, la formation des liaisons substrat-soufre est favorisée.

Selon une variante de réalisation compatible avec les variantes de réalisation précédentes, le procédé comporte une étape de purge du réacteur entre l'étape d'injection de la molécule soufrée et l'étape d'injection de dihydrogène.

Un second aspect de l'invention concerne un film en disulfure de vanadium susceptible d'être obtenu par le procédé selon un premier aspect de l'invention, caractérisé en ce que, déposé sur un substrat présentant une transmittance supérieure à 50% pour une longueur d'onde comprise entre 450 et 2750 nm, le film ait une transmittance supérieure à 50% pour une longueur d'onde comprise entre 450 et 2750 nm.

Ainsi, le film obtenu est transparent.

Selon une variante de réalisation, le film présente une rugosité inférieure à 0,3 nm.

Selon une variante de réalisation, le film est déposé de manière conforme sur le substrat.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
- La figure 1 montre un schéma synoptique représentant l'enchaînement des étapes d'un procédé de fabrication selon un premier aspect de l'invention.
- La figure 2 montre une représentation schématique d'un film selon un second aspect de l'invention obtenu par le procédé selon un premier aspect de l'invention.
- La figure 3 est un graphe illustrant la transmittance en pourcentage en fonction de la longueur d'onde en nanomètres pour un substrat et pour un film selon un second aspect de l'invention ayant une épaisseur de 6 nm déposé sur le substrat.
- La figure 4 est un graphe illustrant l'intensité en unité de masse atomique unifiée en fonction de l'énergie en électronvolts pour l'orbital atomique de l'azote, obtenu par spectrométrie photo-électronique X sur le film selon un second aspect de l'invention avec ou sans une étape de cristallisation thermique.

### DESCRIPTION DETAILLEE

Sauf précision contraire, un même élément apparaissant sur des figures différentes présente une référence unique.

Un premier aspect de l'invention concerne un procédé de fabrication d'un film en disulfure de vanadium, de formule chimique VS₂ et un second aspect de l'invention concerne un film en disulfure de vanadium obtenu par le procédé selon un premier aspect de l'invention.

On entend par « film », une mince pellicule de matériau recouvrant une surface, par exemple de l'ordre de quelques nanomètres d'épaisseur.

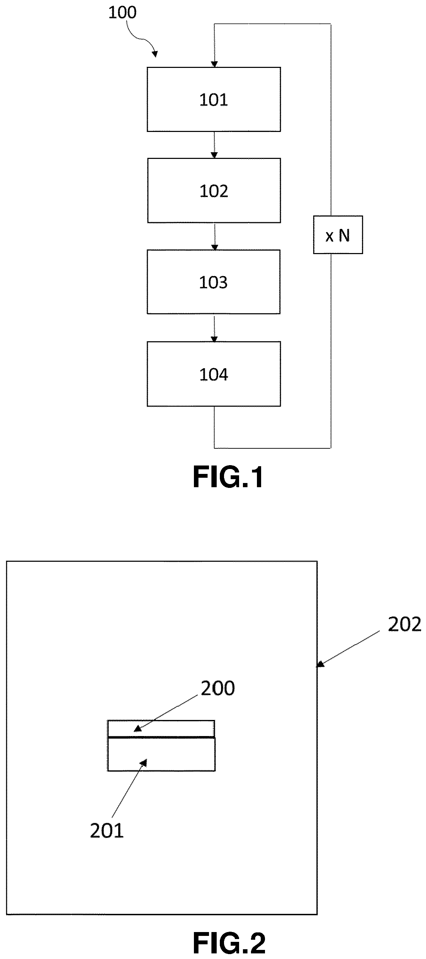

[Fig 2] La figure 2 montre une représentation schématique du film 200 selon un second aspect de l'invention obtenu par le procédé selon un premier aspect de l'invention.

Le procédé selon un premier aspect de l'invention est réalisé dans un réacteur 202 sous vide. Le volume du réacteur 202 est généralement inférieur à 5 litres. La pression dans le réacteur 202 est par exemple de 2 Torr. Selon une réalisation, l'ensemble des étapes du procédé sont réalisées dans ce réacteur 202 sous vide.

Le procédé selon un premier aspect de l'invention est un dépôt chimique en phase vapeur, ou dépôt CVD pour « Chemical Vapor Deposition », sur un substrat 201.

Le substrat 201 est par exemple du silicium Si, du dioxyde de silicium SiO₂, du carbure de silicium SiC, du saphir Al₂O₃, un oxyde des métaux de transition tel que TiO₂, ZrO₂, HfO₂, VO₂, V₂O₅, NbO₂, Nb₂O₅, Ta₂O₅, MₒOₓ, WOₓ, SnO₂, InₓSn_{y}O_{z}, ZnO, CuOₓ, NiOₓ, ZnO AlₓZn_{y}O_{z}, GaₓZn_{y}O_{z} ou AlₓGa_{y}Zn_{z}O_{w}, du nitrure d'aluminium l'AlN, du nitrure de gallium GaN, du nitrure de titane TiN, du tungstène W, un sulfure ou séléniure ou tellure des métaux de transition TiS₂, ZrS₂, HfS₂, NbS₂, TaS₂, MOS₂, WS₂, ZnS, SnS₂, NiSₓ, InSₓ, GaSₓ, InₓGa_{y}S_{z}, TiSe₂, ZrSe₂, HfSe₂, NbSe₂, TaSe₂, MoSe₂, WSe₂, ZnSe, InSeₓ, GaSeₓ, NiSeₓ, InₓNi_{y}Se_{z} InₓGa_{y}Se_{z}, TiTe₂, ZrTe₂, HfTe₂, NbTe₂, TaTe₂, MoTe₂, WTe₂, ZnTe, ou un chalcogénure CdTe, CdₓZn_{y}Te_{z}, GeTe, GeₓSb_{y}Te_{z}, GeₓN_{y}Te_{z}, x, y et z étant des entiers naturels.

Le substrat 201 est transparent, c'est-à-dire qu'il présente une transmittance supérieure ou égale à 50% pour une longueur d'onde donnée.

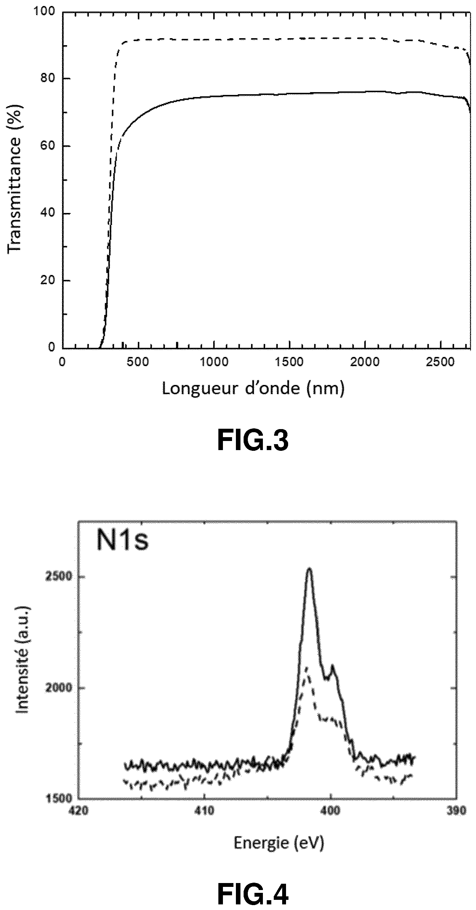

[Fig 3] Par exemple, sur la figure 3, le substrat 201 est en borosilicate et présente une transmittance supérieure à 80% pour une longueur d'onde comprise entre 300 et 2700 nm.

Le substrat 201 est préalablement chauffé, par exemple à une température comprise entre 100°C et 250°C.

La surface du substrat 201 peut être préalablement préparée pour faciliter les réactions, et notamment pour retirer les condensats humides, par exemple par débit de gaz. Le gaz utilisé est un gaz réducteur, par exemple du dihydrogène H₂, du diazote N₂ ou de l'argon Ar. La préparation du substrat 201 est par exemple réalisée après le chauffage du substrat 201.

La préparation du substrat 201 peut également être réalisée en présence d'un traitement plasma pour diminuer le temps global de réalisation du procédé. La préparation du substrat 201 par traitement plasma est par exemple réalisée après la préparation du substrat 201 par débit de gaz.

La préparation du substrat 201 peut également comporter une sous-étape d'exposition de la surface du substrat 201 à une molécule soufrée. Cette molécule soufrée est par exemple identique à celle qui sera injectée dans le réacteur 202 lors d'une étape décrite plus loin, dite troisième étape, du procédé selon un premier aspect de l'invention.

[Fig 1] La figure 1 montre un schéma synoptique représentant l'enchaînement des étapes du procédé 100 selon un premier aspect de l'invention.

Les étapes 101 à 104 du procédé 100 selon un premier aspect de l'invention sont réalisées au moins une fois, c'est-à-dire que le procédé 100 selon un premier aspect de l'invention comporte au moins un cycle.

Une première étape 101 du procédé 100 selon un premier aspect de l'invention consiste à injecter au moins une molécule organométallique de vanadium dans le réacteur 202. Autrement dit, la première étape 101 consiste à injecter un composant comprenant au moins une molécule organométallique de vanadium dans le réacteur 202, le composant étant par exemple un gaz.

On entend par « molécule organométallique », une molécule comportant au moins un atome de carbone et un métal de cœur. Une molécule organométallique peut par exemple aussi inclure au moins un atome d'azote en liaison directe avec le métal de cœur ; c'est notamment le cas des amidures métalliques.

Dans la suite de la description, on appelle « molécule organométallique de vanadium », une molécule comportant des atomes de carbone et un atome de vanadium comme métal de cœur.

Dans la molécule organométallique de vanadium, le vanadium a une valence comprise entre 1 et 4. On entend par « valence », le nombre de liaisons covalentes qu'un atome a formées dans une molécule.

La molécule organométallique de vanadium est par exemple du tétrakis(éthylméthylamino)vanadium(IV) TEMAV, du tétrakis(diméthylamido)vanadium(IV) TDMAV, du tétrakis(diéthylamino)vanadium(IV) TDEAV, du bromure de vanadium VBr₃, les molécules comportant du vanadium et une fonctionnalisation cyclopentadiényle et/ou comportant une fonctionnalisation carbonyle, par exemple le bis(cyclopentadiényl)vanadium, le vanadium hexacarbonyl V(CO)₆ ou encore le vanadium tétracarbonyl cyclopentadiènide. Les organométalliques halogénés peuvent aussi être utilisés en valence inférieure ou égale à 4 avec le vanadium, par exemple Bis(cyclopentadienyl)vanadium dichloride.

La molécule organométallique de vanadium peut également être du tétrachlorure de vanadium VCl₄ ou du chlorure de vanadium(III) VCl₃.

Le procédé 100 selon un premier aspect de l'invention peut également fonctionner pour une molécule organométallique de vanadium dans laquelle le vanadium a une valence strictement supérieure à 4 si une étape de réduction est réalisée sur le film 200 finalement obtenu par le procédé 100 pour faire chuter la stœchiométrie du film 200 et obtenir un disulfure. Cette étape de réduction est par exemple réalisée en présence d'un plasma réducteur à base de dihydrogène.

La molécule organométallique de vanadium peut être injectée pure ou diluée dans un solvant organique. Par exemple, le solvant organique présente une pression de vapeur saturante plus élevée que la molécule organométallique de manière que le solvant organique s'évapore sans interagir sur le film 200. Le solvant organique est par exemple de l'octane ou du cyclohexane. La molécule organométallique est par exemple diluée à 0.1 mole/litre dans le solvant organique.

La durée de l'injection de la molécule organométallique de vanadium 101 dépend de la vitesse de greffage de la molécule organométallique de vanadium sur le substrat 201 lors d'un premier cycle, ou sur la surface du film généré au cycle précédent pour des cycles suivants. Généralement, la durée de la première étape 101 est inférieure à 2 secondes.

La durée optimale de la première étape 101 est par exemple obtenue, après un nombre fini de cycles, une fois qu'une courbe de saturation représentant la vitesse de croissance du cycle en fonction du temps de greffage de la molécule organométallique atteint un palier.

Une deuxième étape 102 du procédé 100 selon un premier aspect de l'invention consiste à purger le réacteur 202.

La deuxième étape 102 du procédé 100 selon un premier aspect de l'invention est par exemple réalisé par un débit de gaz neutre.

La deuxième étape 102 du procédé 100 selon un premier aspect de l'invention est par exemple réalisé par des étapes successives de tirage à vide et recharge en gaz neutre du réacteur 202. Le nombre d'étapes de tirage à vide et recharge en gaz neutre est par exemple choisi pour s'assurer que la molécule organométallique soit éliminée du réacteur 202.

Le gaz neutre utilisé est par exemple du diazote N₂, de l'argon Ar, ou de l'hélium He.

La durée de la deuxième étape 102 dépend de la géométrie du réacteur 202 et de la capacité de pompage de ce dernier. Pour un réacteur 202 ayant un volume inférieur à 5 litres et une pompe dite primaire, la durée de la deuxième étape 102 est inférieure à 2 secondes.

La durée optimale de la deuxième étape 102 est par exemple obtenue, après un nombre fini de cycles, une fois qu'une courbe de saturation représentant la vitesse de croissance du cycle en fonction du temps de purge atteint un palier.

Une troisième étape 103 du procédé 100 selon un premier aspect de l'invention consiste à injecter au moins une molécule soufrée.

On entend par « molécule soufrée », une molécule comportant au moins un atome de soufre. Selon un premier mode de réalisation, la molécule soufrée comporte au moins un groupement thiol libre. Un groupement thiol est un groupement de formule générique R-SH où R est un résidu organique et SH le groupe sulfhydryle.

Selon un deuxième mode de réalisation, la molécule soufrée forme un intermédiaire réactionnel comportant au moins un groupement thiol libre. On entend par « intermédiaire réactionnel », une espèce participant à un mécanisme réactionnel et qui n'est ni un réactif, ni un produit de la réaction.

La molécule soufrée est par exemple de l'éthane di-thiol EDT, du sulfure d'hydrogène H₂S, du disulfure de diméthyle DMDS, du disulfure de diéthyl DEDS, du disulfure de dipropyl DPDS, du disulfure de dibenzyl DBDS, ou encore du disulfure de di-tert-butyl DTBDS. La molécule soufrée peut être mélangée avec du dihydrogène H₂.

La troisième étape 103 du procédé 100 selon un premier aspect de l'invention peut être réalisée en présence d'un plasma réducteur.

La molécule soufrée peut être injectée pure ou mélangée avec du dihydrogène H₂ et/ou mélangée avec un gaz porteur neutre. Le gaz porteur neutre est par exemple du diazote N₂ ou de l'argon Ar ou l'hélium He.

La durée de la troisième étape 103 dépend de la vitesse de greffage de la molécule soufrée. Généralement, la durée de la troisième étape 103 est inférieure à 2 secondes.

La troisième étape 103 du procédé 100 selon un premier aspect de l'invention peut être suivie d'une étape de purge du réacteur 202. Cette étape de purge du réacteur 202 peut être identique à la deuxième étape 102 de purge du réacteur 202 et permet d'accélérer la réaction en garantissant la séparation des chimies.

Une quatrième étape 104 du procédé 100 selon un premier aspect de l'invention consiste à injecter un gaz réducteur dans le réacteur 202. Le gaz réducteur est par exemple du dihydrogène H₂.

Le gaz réducteur peut être injecté pur ou mélangé avec un gaz porteur neutre. Le gaz porteur neutre est par exemple du diazote N₂, de l'argon Ar ou de l'hélium He.

La quatrième étape 104 du procédé 100 selon un premier aspect de l'invention peut comporter une sous-étape de traitement du substrat 200 par plasma réducteur. Le plasma réducteur est par exemple à base de dihydrogène H₂. Cette sous-étape de traitement du substrat 200 permet de réduire le temps global du procédé 100.

Les étapes 101 à 104 du procédé 100 sont par exemple réalisées à une température inférieure à 250°C.

Comme illustré sur la figure 1, les étapes 101 à 104 du procédé 100 selon un premier aspect de l'invention sont réalisées N fois afin d'atteindre l'épaisseur souhaitée. N est par exemple compris entre 1 et 10⁵ cycles. Le nombre de cycle N est ajusté en fonction de la vitesse de croissance par cycle pour atteindre l'épaisseur souhaitée.

À chaque cycle, l'épaisseur du film 200 de disulfure de vanadium augmente. La vitesse de croissance est comprise entre 0.5 et 2 Angström par cycle. Le film 200 a alors une épaisseur de 10 nm au bout d'une centaine de cycles.

A l'issue du procédé 100, l'épaisseur du film 200 est par exemple compris entre 6 et 10 nm.

Le film 200 ainsi obtenu présente une résistivité inférieure à 1500 µΩ.cm, une rugosité inférieure à 0,3 nm et un travail de sortie supérieur à 4,6 eV.

On entend par « rugosité du film », la valeur absolue de la différence maximale de hauteur entre une irrégularité de la surface du film et une ligne de surface théorique. La rugosité est donc une rugosité de surface.

De plus, comme illustré sur la figure 3, le film 200 déposé sur le substrat 201, puis recuit à 450°C présente une transmittance supérieure à 60% pour une longueur d'onde comprise entre 300 et 2700 nm et une épaisseur de 6 nm, ce qui signifie que le film 200 est transparent, bien que l'on constate que le dépôt du film 200 sur le substrat 201 transparent induit une chute de la transmittance.

Comme visible sur la figure 3 le film 200 déposé sur le substrat 201 présente une transmittance supérieure à 50% pour une longueur d'onde comprise entre 350 et 2700 nm, une transmittance supérieure à 60% pour une longueur d'onde comprise entre 400 et 2700 nm, une transmittance supérieure à 70% pour une longueur d'onde comprise entre 650 et 2700 nm et une transmittance supérieure à 75% pour une longueur d'onde comprise entre 1100 et 2700 nm.

Il est à noter que l'épaisseur du film 200 est constante sur toute sa superficie, on obtient donc avec ce procédé 100 un film 200 dont le dépôt est conforme.

On définit la résistivité comme l'inverse de la conductivité.

Pour améliorer les caractéristiques du film 200 de disulfure de vanadium, c'est-à-dire pour obtenir un film présentant une plus faible résistivité, une plus faible rugosité et un travail de sortie plus élevé, une étape de cristallisation thermique peut être réalisée après la quatrième étape 104 du procédé 100 selon un premier aspect de l'invention.

L'étape de cristallisation thermique consiste par exemple en un recuit à 450°C pendant 10 minutes sous argon Ar. Un autre exemple est un traitement thermique à 950°C sous flux d'éthane di-thiol EDT, conduisant à la cristallisation complète du film.

A l'issue de cette étape de cristallisation thermique, le film 200 a une résistivité inférieure à 500 µΩ.cm, une rugosité inférieure à 0,2 nm et un travail de sortie supérieur à 5 eV.

Il est possible de démontrer qu'un film 200 selon un second aspect de l'invention a été obtenu par le procédé 100 selon un premier aspect de l'invention en réalisant une spectrométrie photo-électronique X du film 200.

[Fig 4] La figure 4 est un graphe illustrant l'intensité en unité de masse atomique unifiée a.u. en fonction de l'énergie en électronvolts eV pour l'orbital atomique de l'azote N1 s obtenu par spectrométrie photo-électronique X sur le film 200.

On constate un pic représentant l'état des liaisons avec l'azote dans le film 200, témoin de résidus d'azote dans le film 200. Ainsi, si le film 200 a été obtenu en utilisant une molécule organométallique de vanadium amine comme le TEMAV par exemple, une spectrométrie photo-électronique X réalisée pour l'orbital de l'azote permettra d'identifier des résidus d'azote.

De même, si le film 200 a été obtenu en utilisant une molécule organométallique de vanadium chlorée, une spectrométrie photo-électronique X réalisée pour l'orbital du chlore permettra d'identifier des résidus de chlore et si le film 200 a été obtenu en utilisant une molécule organométallique de vanadium bromée, une spectrométrie photo-électronique X réalisée pour l'orbital du brome permettra d'identifier des résidus de brome.

Sur la figure 4, la courbe en traits pointillés est relative à un film 200 obtenu avec une étape de cristallisation thermique et la courbe en traits pleins est relative à un film 200 obtenu sans étape de cristallisation thermique.

L'étape de recristallisation thermique permet donc également de diminuer la quantité de résidus dans le film 200.

De manière alternative ou en combinaison, il est possible de démontrer qu'un film 200 a été obtenu par le procédé 100 selon l'invention en observant par microscopie électronique à balayage que le dépôt du film est conforme, c'est-à-dire qu'il présente une même épaisseur sur toute sa surface. Lors de cette observation, il est également possible de vérifier que le film est bien fermé, c'est-à-dire non poreux ou peu poreux.

De manière alternative ou en combinaison, il est possible de démontrer qu'un film 200 a été obtenu par le procédé 100 selon l'invention en réalisant une réflectométrie X (XRR) montrant que le film présente une rugosité inférieure à 0,3 nm, quelle que soit l'épaisseur déposée.

## Revendications

1. Film (200) en disulfure de vanadium destiné à être déposé sur un substrat (201) présentant une transmittance supérieure à 50% pour une longueur d'onde comprise entre 450 et 2750 nm, ayant une transmittance supérieure à 50% pour une longueur d'onde comprise entre 450 et 2750 nm, **caractérisé en ce que** le film (200) présente une rugosité de surface inférieure à 0,3 nm, la rugosité de surface étant mesurée par réflectométrie X.

2. Film (200) selon la revendication 1, **caractérisé en ce que** le film (200) est destiné à être déposé de manière conforme sur le substrat (201).

3. Film (200) selon l'une quelconque des revendications précédentes, **caractérisé en ce que** le film (200) présente une épaisseur comprise entre 6 et 10 nm.

4. Film (200) selon l'une quelconque des revendications précédentes, **caractérisé en ce que** le film (200) a une transmittance supérieure à 60% pour une longueur d'onde comprise entre 450 et 2750 nm.

5. Procédé (100) de fabrication d'un film (200) en disulfure de vanadium selon l'une quelconque des revendications précédentes, par dépôt chimique en phase vapeur sur un substrat (201), comportant une étape de chauffage du substrat (201) et des étapes successives réalisées dans un réacteur (202) sous vide :
i. Injection d'au moins une molécule organométallique de vanadium, le vanadium ayant une valence inférieure ou égale à 4 (101) ;
ii. Purge du réacteur (202, 102) ;
iii. Injection d'au moins une molécule soufrée comportant au moins un groupement thiol libre ou formant un intermédiaire réactionnel comportant au moins un groupement thiol libre (103) ;
iv. Injection d'un gaz réducteur (104).

6. Procédé (100) de fabrication selon la revendication 5, **caractérisé en ce que** les étapes i. à iv. (101, 102, 103, 104) sont répétées une pluralité de fois.

7. Procédé (100) de fabrication selon l'une quelconque des revendications 5 à 6, **caractérisé en ce que** les étapes i. à iv. (101, 102, 103, 104) sont réalisées à une température inférieure à 250°C.

8. Procédé (100) de fabrication selon l'une quelconque des revendications 5 à 7, **caractérisé en ce que** le substrat (201) est chauffé à une température comprise entre 100°C et 250°C.

9. Procédé (100) de fabrication selon l'une quelconque des revendications 5 à 8, **caractérisé en ce que** la molécule organométallique de vanadium est choisie parmi les molécules suivantes : tetrakis(ethylmethylamino)vanadium(IV) TEMAV, tetrakis(dimethylamido)vanadium(IV) TDMAV, tetrakis(diethylamino)vanadium(IV) TDEAV, bromure de vanadium VBr3, les molécules comportant une fonctionnalisation cyclopentadiényle et/ou comportant une fonctionnalisation carbonyle ou les molécules halogénées de valence inférieure ou égale à 4.

10. Procédé (100) de fabrication selon l'une quelconque des revendications 5 à 8, **caractérisé en ce que** la molécule organométallique de vanadium est du tétrachlorure de vanadium VCl₄ ou du chlorure de vanadium VCl₃.

11. Procédé (100) de fabrication selon l'une quelconque des revendications 5 à 10, **caractérisé en ce que** la molécule soufrée est choisie parmi les molécules suivantes : éthane di-thiol EDT, sulfure d'hydrogène H₂S, disulfure de diméthyle DMDS, disulfure de diéthyl DEDS, disulfure de dipropyl DPDS, disulfure de dibenzyl DBDS, disulfure de di-tert-butyl DTBDS.

12. Procédé (100) de fabrication selon l'une quelconque des revendications 5 à 11, **caractérisé en ce que** la molécule soufrée est mélangée avec du dihydrogène.

13. Procédé (100) de fabrication selon l'une quelconque des revendications 5 à 12, **caractérisé en ce que** le gaz réducteur injecté est du dihydrogène.

14. Procédé (100) de fabrication selon l'une quelconque des revendications 5 à 13, **caractérisé en ce que** l'étape (104) d'injection d'un gaz réducteur comporte une sous-étape de traitement plasma réducteur à base d'hydrogène.

15. Procédé (100) de fabrication selon l'une quelconque des revendications 5 à 14, **caractérisé en ce que** la surface du substrat (201) est préparée par débit de gaz réducteur.

16. Procédé (100) de fabrication selon la revendication 15, **caractérisé en ce que** la préparation de la surface du substrat (201) comporte une sous-étape de traitement plasma.

17. Procédé (100) de fabrication selon l'une quelconque des revendications 15 à 16, **caractérisé en ce que** la préparation de la surface du substrat (201) comporte une sous-étape d'exposition à une molécule soufrée.

18. Procédé (100) de fabrication selon l'une quelconque des revendications 5 à 17, **caractérisé en ce qu'**il comporte une étape de purge du réacteur entre l'étape (103) d'injection de la molécule comportant au moins un thiol libre et l'étape (104) d'injection d'un gaz réducteur, le gaz réducteur étant du dihydrogène.

19. Procédé (100) de fabrication selon l'une quelconque des revendications 5 à 18, **caractérisé en ce que** l'étape (101) d'injection de la molécule organométallique de vanadium comporte une étape d'injection d'un composant comprenant la molécule organométallique de vanadium.
